Europäisches Patentamt

European Patent Office

Office européen des brevets

(19)

(11) Publication number: **0 045 584**
**B1**

# EUROPEAN PATENT SPECIFICATION

(45) Date of publication of patent specification: **08.02.84**

(51) Int. Cl.³: **H 01 L 39/24**

(21) Application number: **81303261.2**

(22) Date of filing: **15.07.81**

(54) Methods of making multifilament superconductors.

(30) Priority: **04.08.80 US 175119**

(43) Date of publication of application:
**10.02.82 Bulletin 82/6**

(45) Publication of the grant of the patent:
**08.02.84 Bulletin 84/6**

(84) Designated Contracting States:
**DE FR GB**

(56) References cited:
**US - A - 3 796 553**
**US - A - 4 053 976**

(73) Proprietor: The BOC Group, Inc.
85 Chestnut Ridge Road
Montvale, New Jersey 07645 (US)

(72) Inventor: Marancik, William G
94 Cross Road
Basking Ridge New Jersey 07920 (US)

(74) Representative: Wickham, Michael et al,
c/o Patent and Trademark Department BOC
Limited Hammersmith House
London W6 9DX (GB)

Courier Press, Leamington Spa, England.

## Methods of making Multifilament Superconductors

This invention relates to composite superconducting wires of the type in which many very fine filaments of a metal, metal alloy or intermetallic compound having zero electrical resistance at or below a specified cryogenic temperature are embedded as a distributed array in a matrix of a non-superconducting material, usually a metal or metal alloy of normal electrical conductivity. Representative prior art composite superconducting wires of this type may have a diameter of the order of 0.3 mm and contain from several hundred to several thousand distributed filaments of superconducting material such as NbTi or $Nb_3Sn$ embedded in a matrix of Cu or a copper alloy.

Composite superconducting wire characterised by multiple longitudinally extending strands of high-field superconducting alloy in a surrounding matrix of copper or similar good electrical and thermal conductor, has found increasing application for use in the coils of superconducting magnets capable of producing extremely high magnetic fields.

Composite superconducting wire of the foregoing type is typically produced by initial preparation of a billet comprised of a copper extrusion can which contains a plurality of close-packed hexagonally-formed rod inserts. Each such rod insert may typically consist of one or more rods of a Type II superconductor, such as a niobium-titanium alloy, embedded in a matrix of high purity OFHC copper, the unit being drawn to a cohesive hexagonal bar before insertion into the extrusion can. The can containing the packed rods is suitably sealed at its end and thereupon subjected to extrusion or swaging and drawing operations, which gradually reduce the diameter of the billet and of the contained inserts. The final very small diameter fine wire achieved by this technique contains the individual strands of the superconductor alloy in the surrounding copper matrix.

In the case of several of the more significant high-field Type II conductors, the procedure outlined above may not be readily employed. In particular, intermetallic compounds such as $V_3Ga$ and $Nb_3Sn$, which are among the presently recognised more useful Type II superconductors, are so brittle in nature, that the drawing processes are ineffective in working them. Indeed, taking recognition of this problem it has been proposed to prepare composite superconducting wire based upon such high-field intermetallic Type II superconductors, by preparing a billet structure similar to that described above, but utilising as the rod inserts vanadium or niobium surrounded by a matrix of Ga-bronze or of Sn-bronze. Pursuant to this approach the billet is appropriately reduced, in a manner similar to that indicated for the Nb-Ti composite wire, and after the desired fine diameter composite wire is achieved, the resultant product is subjected to a prolonged heating schedule — which serves to diffuse the gallium or tin into the central conductor to form the desired superconducting alloy thereat. In a modification of this specie the matrix may be pure Cu instead of bronze and the Sn or Ga added by diffusion from the outside of the composite, after it has achieved its final diameter.

Superconducting wire made as above described may contain thousands of superconducting filaments in a composite conductor of no more than 0.3 mm diameter. However, the intent in such conductors is to provide a discrete predetermined number of continuous filaments. An alternative that has been explored is a composite superconductor in which an intermediate number of smaller and more closely packed discontinuous superconductive filaments are formed by mechanical elongation of a rod, wire or strip of normal conductor containing dispersed inclusions of superconducting material. An example of such an approach is disclosed in US patent 3 815 224 in which a porous strip of Nb is infiltrated with Sn and thereafter mechanically elongated. In another version, a mixture of superconducting and non-superconducting powders are compacted and drawn. A more sophisticated approach is that disclosed by Tsuei in *Science,* Vol 180, 6 April 1973, p 57; by Tsuei in AEC Research and Development Report No. 47, under Contract No. AT(04—3)—822, dated October 1973, and entitled 'Superconducting Composite of Copper and Niobium — A Metallurgical Approach'; and by Tsuei, Suenaga and Sampson in AEC Research and Development Report No. 49, under Contract No. AT(04—3)—822, dated December 1973, and entitled 'Critical Current Density of a Superconducting Copper-Base Alloy Containing $Nb_3Sn$ Filaments'. In this method, a superconducting phase or a superconducting precursor phase is formed as a distributed precipitate in a normally conducting ductile matrix by chill casting. Subsequent mechanical reduction and heat treatment produces elongated superconducting inclusions that function much the same as the continuous superconducting filaments previously described. From this and other work, it is known that high density of very fine discontinuous superconducting filaments in a normally conducting metal matrix provide a useful stabilised superconductor that appears to have some advantages over the conventional continuous filaments product with a finite predetermined number of filaments.

The invention as claimed is intended to provide a new form of stabilised multifilament superconductor having improved electrical and mechanical properties.

Another aim of this invention is to provide a method of making a multifilament superconductor comprising a large number of superconducting filaments distributed in a matrix of normal conductor.

With the method of the invention, conductors having several million equivalent superconducting filaments can be made.

In this specification the term 'superconducting precursor material' is used to describe metals and alloys that themselves become superconducting at cryogenic temperatures and also to describe metals such as Nb or V that can be reacted with another metal, such as Sn or Ga, to form a superconducting compound.

In accordance with the invention, discrete short lengths of fine filaments of superconducting precursor material are dispersed in a normal conductor in an extrusion billet. This is extruded and further elongated by rolling and/or wire drawing and, where necessary, heat treated to produce the final conductor. The short length filaments may be cut lengths of wire of a superconducting material such as NbTi or of a superconductor precursor such as Nb or V which may be reacted with Sn or Ga in the finished product to form $Nb_3Sn$ or $V_3Ga$. The normal conductor, usually Cu or Al, may be in powder form which is compacted around the short, randomly dispersed filaments to form a monolithic matrix or it may be in the form of a tube or spiral wrap sheathing each filament. During subsequent compacting and extrusion, the adjacent sections of tube or wrap are consolidated into a monolithic matrix. Several species are described herein.

Embodiments of the invention will now be described, by way of example, reference being made to the Figures of the accompanying drawings in which:

Figure 1 is a flow sheet illustrating a first method of manufacturing a multifilament superconductor according to the present invention; and

Figure 2 is a flow sheet illustrating an alternative method of manufacturing a multifilament superconductor according to the present invention.

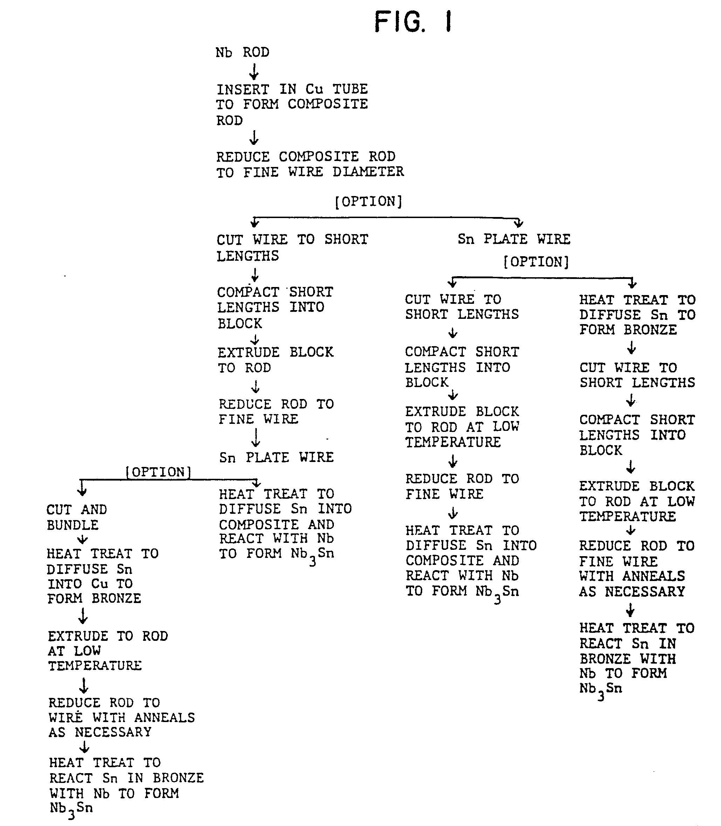

Referring first to Figure 1, a 3.05 m length of Nb rod of 3.5 mm diameter is inserted into a Cu tube having a wall thickness of 0.89 mm and an outside diameter of 6.35 mm. This composite rod is then reduced in diameter and elongated by drawing, swaging and/or rolling to produce a Cu sheathed Nb wire with an outside diameter of 0.62 mm and an Nb core diameter of 0.35 mm. This fine diameter composite wire is then cut into 6.2 mm lengths. The ratio of length to diameter of the individual core wire segments should be in the range from 10 to 100. Maximum acceptable diameter and length for the cut core wire segments depends on the ultimate extrusion billet size, that is, on the amount of reduction that will follow. As a guide however, maximum wire diameter should be about 2.5 mm and maximum segment length about 50 mm. These short lengths of sheathed wire are loosely and randomly placed in a suitable mold and compacted in a press to form a composite block consisting of short lengths of Nb in a Cu matrix which is substantially free of voids. Within the capacity of the press, this compressed block formed from the short lengths of Cu sheathed Nb wire can be any desired size and shape. Typically, wafers of circular or hexagonal cross section are formed having a diameter (or equivalent dimension in the case of hexagonal form) of from 25.4 mm to 190.5 mm. As a specific example, a cylindrical block 19 cm in diameter and 7.6 cm thick may be formed under a pressure of 10,000 psi.

As the next process step, these blocks must be extruded to rod. This is conveniently done by inserting a stack of five such blocks into a cylindrical extrusion can. A suitable extrusion can may be made of Cu, have a 1.3 cm wall thickness and 20.3 cm inside diameter cavity of sufficient length to receive a stack of five thick blocks. The extrusion billet containing the composite blocks is then sealed by welding on a copper cap and evacuated through a pigtail as is well known in the art. The length of each discrete short length of wire embedded in the matrix should not exceed 20% and preferably should not exceed 10% of the extrusion billet length. The billet is extruded at between 500°C and 1000°C to reduce its cross sectional area by a factor of from 16 to over 100. Typically, the 22.8 cm O.D. billet described above is extruded at 1000°C and an area reduction of 100 to produce 2.3 cm diameter rod. During the extrusion step the Cu to Cu interfaces are erased to form a monolithic Cu matrix in which the now elongated but dicontinuous Nb filaments are distributed.

The 2.3 cm diameter rod may then be rolled or drawn to wire, for example, 0.30 mm diameter. The resultant contained Nb filaments are generally axially orientated and have individual filament diameters of the order of 0.5 microns. The core of the wire (section of the wire excluding the original billet wall) contains 31% Nb and the equivalent of about 100,000 Nb filaments. The overall area percentage of Nb including the billet wall is 27%.

This 0.30 mm composite wire is next coated with a 0.025 mm thick layer of Sn which may be applied by any conventional tinning technique. The tinned wire is then heat treated as is well known in the superconductor art to cause the Sn to diffuse into the Cu matrix and react with the contained Nb filaments to form $Nb_3Sn$, the superconducting compound, in the final conductor.

If a final conductor having even more filaments is desired, the tinned and unreacted conductor can be cut and bundled in a second extrusion can. However, before extrusion, the billet is heat treated to cause the Sn to diffuse into the Cu to form Cu-Sn bronze. The temperature and time is selected so as not to cause reaction of the Nb and Sn. The billet is now essentially Nb filaments in a Cu-Sn bronze matrix. The billet is then extruded to rod as before but at an extrusion temperature of about 400°C to 500°C to prevent $Nb_3Sn$ formation. The rod is then worked to the desired final wire diameter with intermediate anneals as necessary to prevent undue work hardening of the bronze. The final diameter wire is then heat treated for a time and at a temperature to cause formation of $Nb_3Sn$ on the Nb filaments, as is well known in the art.

Still other variations of the species of Figure 1 are shown as options in which the composite fine wire is tinned before being cut, compacted and extruded. Further description of these variations is believed unnecessary.

The principle point of novelty in this invention is the extremely large number of very fine, but continuous, filaments in the final product resulting from the use of the discrete short lengths of wire as the source of filaments. The invention is not limited to superconducting materials of the $A_3B$ type nor is it limited to the form or composition of the starting matrix material. For example, the ultimate superconducting filaments may be NbTi which may be the composition of the original rods inserted in the Cu tube of the above example. In such case, no Sn layer is required and no diffusion or reaction step is required. Instead of the Cu tube, the Cu matrix material may be provided as Cu foil wrapped around the Nb or NbTi rod. In a more radical departure from the example first described in detail above, the Cu matrix material for the NbTi conductor or the Cu and Sn for the $Nb_3Sn$ conductor can be provided as metal powders. An illustrative example follows.

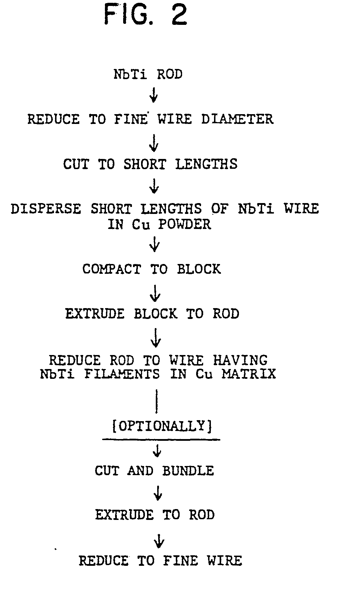

Referring to Figure 2, a suitable starting material is Nb (45%) Ti (55%) in rod form. This is reduced by drawing or the like to fine wire diameter and cut to short lengths. These short lengths of fine wire are then uniformly dispersed in a mass of Cu powder which is then compacted to a substantially void free composite body. One or more of these compacted bodies are then inserted in a Cu extrusion can and extruded to form composite rod, which is then mechanically reduced to the ultimate fine wire diameter. As before, an option is cutting and bundling and extruding a second time for even more and finer filaments.

When $Nb_3Sn$ conductor is to be made by this technique from Nb rod, mixed Cu and Sn powder may be substituted for the Cu powder and the final product is reaction heat treated.

An almost endless number of alternatives will immediately suggest themselves to the superconductor designer once it is recognised that the very large number of discontinuous filaments attainable using 'chopped wires' as the source of such filaments perform at least as well, if not better than, the more finite number conventionally derived from harder to fabricate continuous filament precursors. With the method of the present invention, conductors having several million equivalent superconducting filaments are easy to obtain.

**Claims**

1. A method of making a multifilament superconductor characterised by the steps of: dispersing discrete short lengths of superconductor precursor wire in a matrix of normally conducting metal to form a composite body, extruding the composite body to elongate it while reducing the transverse cross-section of the body and further elongating the extruded product by mechanical working.

2. A method as claimed in claim 1, in which the discrete lengths of superconductor precursor wire are individually sheathed in normally conducting metal and the composite body is formed by compacting a plurality of sheathed lengths of superconductor precursor wire.

3. A method as claimed in claim 1, in which the discrete lengths of superconductor precursor wire are dispersed in a matrix of normally conducting metal powder and the composite body is formed by compacting.

4. A method as claimed in claim 1, 2 or 3 in which prior to extrusion, the length of each discrete superconductor precursor wire does not exceed 20% of the length of the extrusion billet.

5. A method as claimed in any preceding claim, in which the superconductor precursor wire is selected from NbTi and NbZr and the normally conducting metal is Cu.

6. A method as claimed in any of claims 1 to 4, in which the superconductor precursor wire is an intermetallic compound of the type $A_3B$, consisting of wire of metal A into which a metal B is introduced by external diffusion.

7. A method as claimed in any one of claims 1 to 4, in which the superconductor precursor wire is an intermetallic compound of the type $A_3B$, the wire being of metal A whilst metal B constitutes a component of the normally conducting metal powder and the component $A_3B$ is formed by reaction heat treatment after the product has been reduced to its final cross-sectional dimension.

8. A method as claimed in claim 6 or 7, in which metal A is Nb and metal B is Sn or metal A is V and metal B is Ga.

9. A multifilament superconductor made according to the method as claimed in any one of claims 1 to 8 in which each filament is less than 1 micron diameter.

10. A multifilament superconductor as claimed in claim 9, in which the filaments constitute between 10% and 70% of the total cross-sectional area of the superconductor.

**Revendications**

1. Procédé de fabrication d'un supraconducteur à filaments multiples, caractérisé par les étapes qui consistent à disperser des segments courts distincts d'un fil susceptible de devenir supraconducteur dans une matrice en un métal normalement conducteur, de manière à former un corps composite, à extruder ce corps composite pour l'allonger tout en diminuant sa section transversale, puis à allonger encore plus, par travail mécanique, le produit extrudé.

2. Procédé selon la revendication 1, dans lequel les segments distincts du fil susceptible de devenir supraconducteur sont gainés individuellement d'un métal normalement conducteur, et le corps composite est formé par compression de plusieurs de ces segments gainés.

3. Procédé selon la revendication 1, dans lequel les segments distincts du fil susceptible de devenir supraconducteur sont dispersés dans une matrice composée de poudre d'un métal normalement conducteur, et le corps composite est formé par compression.

4. Procédé selon la revendication 1, 2 ou 3, dans lequel, avant l'extrusion, la longueur de chaque segment du fil susceptible de devenir supraconducteur n'est pas supérieure à 20% de celle de la billette d'extrusion.

5. Procédé selon l'une quelconque des revendications précédentes, dans lequel le fil susceptible de devenir supraconducteur est en NbTi ou NbZr et le métal normalement conducteur est Cu.

6. Procédé selon l'une quelconque des revendications 1 à 4, dans lequel le fil susceptible de devenir supraconducteur est un composé intermétallique du type $A_3B$ consistant en un fil en un métal A dans lequel le métal B est introduit par diffusion externe.

7. Procédé selon l'une quelconque des revendications 1 à 4, dans lequel le fil susceptible de devenir supraconducteur est un composé intermétallique du type $A_3B$, ce fil étant en métal A tandis que le métal B constitue un composant de la poudre de métal normalement conducteur et le composant $A_3B$ est formé par traitement thermique avec réaction une fois que le produit a été réduit à sa dimension de section définitive.

8. Procédé selon la revendication 6 ou 7, dans lequel le métal A est Nb et le métal B est Sn, ou le métal A est V et le métal B est Ga.

9. Supraconducteur à filaments multiples fabriqué selon le procédé revendiqué dans l'une quelconque des revendications 1 à 8, dans lequel chaque filament a un diamètre inférieur à 1 micron.

10. Supraconducteur à filaments multiples selon la revendication 9, dans lequel les filaments constituent de 10% à 70% de la section totale du supraconducteur.

**Patentansprüche**

1. Verfahren zur Herstellung eines mehrfädigen Supraleiters, dadurch gekennzeichnet, daß einzelne kurze Abschnitte von Supraleitervorläufer-Draht in einer Matrix aus normal leitendem Metall zur Schaffung eines Verbundkörpers verteilt werden, daß der Verbundkörper zur Auslängung unter Verringerung des Körperquerschnitts stranggepreßt wird und daß das stranggepreßte Produkt durch maschinelle Verarbeitung weiter ausgelängt wird.

2. Verfahren nach Anspruch 1, dadurch gekennzeichnet, daß die einzelnen Abschnitte von Supraleitervorläufer-Draht jeder für sich in normal leitendes Metall eingehüllt werden und daß der Verbundkörper durch Verdichten einer Vielzahl von eingehüllten Abschnitten von Supraleitervorläufer-Draht gebildet wird.

3. Verfahren nach Anspruch 1, dadurch gekennzeichnet, daß die einzelnen Abschnitte von Supraleitervorläufer-Draht in einer Matrix aus normal leitendem Metallpulver verteilt werden und daß der Verbundkörper durch Verdichten geformt wird.

4. Verfahren nach Anspruch 1, 2 oder 3, dadurch gekennzeichnet, daß vor einem Strangpressen die Länge jedes einzelnen Supraleitervorläufer-Drahtes nicht über 20% der Länge des Strangpressungsrohlings hinausgeht.

5. Verfahren nach einem der vorangehenden Ansprüche, dadurch gekennzeichnet, daß der Supraleitervorläufer-Draht ausgewählt wird aus NbTi und NbZr und daß das normal leitende Metall Cu ist.

6. Verfahren nach einem der Ansprüche 1 bis 4, dadurch gekennzeichnet, daß der Supraleitervorläufer-Draht eine intermetallische Verbindung des Typs $A_3B$ ist, die aus Draht des Metalls A besteht, in das ein Metall B durch externe Diffusion engeführt ist.

7. Verfahren nach einem der Ansprüche 1 bis 4, dadurch gekennzeichnet, daß der Supraleitervorläufer-Draht eine intermetallische Verbindung des Typs $A_3B$ ist, daß der Draht aus Metall A besteht, während des Metall B einen Bestandteil des normal leitenden Metallpulvers darstellt und daß der Bestandteil $A_3B$ durch Reaktionshitzebehandlung gebildet wird, nachdem das Produkt auf seine endgültige Querschnittsdimension verringert wurde.

8. Verfahren nach Anspruch 6 oder 7, dadurch gekennzeichnet, daß das Metall A Nb und das Metall B Sn ist, oder daß das Metall A V und das Metall B Ga ist.

9. Mehrfädiger Supraleiter, hergestellt entsprechend dem Verfahren nach einem der Ansprüche 1 bis 8, dadurch gekennzeichnet, daß jeder Faden einen Durchmesser kleiner 1 $\mu$m aufweist.

**0 045 584**

10. Mehrfädiger Supraleiter nach Anspruch 9, dadurch gekennzeichnet, daß die Fäden zwischen 10% und 70% der gesamten Querschnittsfläche des Supraleiters einnehmen.

6

# FIG. 1

Nb ROD
↓
INSERT IN Cu TUBE
TO FORM COMPOSITE
ROD
↓
REDUCE COMPOSITE ROD
TO FINE WIRE DIAMETER

[OPTION]

**CUT WIRE TO SHORT LENGTHS**
↓
COMPACT SHORT
LENGTHS INTO
BLOCK
↓
EXTRUDE BLOCK
TO ROD
↓
REDUCE ROD TO
FINE WIRE
↓
Sn PLATE WIRE

[OPTION]

CUT AND
BUNDLE
↓
HEAT TREAT TO
DIFFUSE Sn
INTO Cu TO
FORM BRONZE
↓
EXTRUDE TO ROD
AT LOW
TEMPERATURE
↓
REDUCE ROD TO
WIRE WITH ANNEALS
AS NECESSARY
↓
HEAT TREAT TO
REACT Sn IN BRONZE
WITH Nb TO FORM
$Nb_3Sn$

HEAT TREAT TO
DIFFUSE Sn INTO
COMPOSITE AND
REACT WITH Nb
TO FORM $Nb_3Sn$

**Sn PLATE WIRE**

[OPTION]

CUT WIRE TO
SHORT LENGTHS
↓
COMPACT SHORT
LENGTHS INTO
BLOCK
↓
EXTRUDE BLOCK
TO ROD AT LOW
TEMPERATURE
↓
REDUCE ROD TO
FINE WIRE
↓
HEAT TREAT TO
DIFFUSE Sn INTO
COMPOSITE AND
REACT WITH Nb
TO FORM $Nb_3Sn$

HEAT TREAT TO
DIFFUSE Sn TO
FORM BRONZE
↓
CUT WIRE TO
SHORT LENGTHS
↓
COMPACT SHORT
LENGTHS INTO
BLOCK
↓
EXTRUDE BLOCK
TO ROD AT LOW
TEMPERATURE
↓
REDUCE ROD TO
FINE WIRE
WITH ANNEALS
AS NECESSARY
↓
HEAT TREAT TO
REACT Sn IN
BRONZE WITH
Nb TO FORM
$Nb_3Sn$

1

**0 045 584**

# FIG. 2

NbTi ROD
↓
REDUCE TO FINE WIRE DIAMETER
↓
CUT TO SHORT LENGTHS
↓
DISPERSE SHORT LENGTHS OF NbTi WIRE
IN Cu POWDER
↓
COMPACT TO BLOCK
↓
EXTRUDE BLOCK TO ROD
↓
REDUCE ROD TO WIRE HAVING
NbTi FILAMENTS IN Cu MATRIX
|
[OPTIONALLY]
↓
CUT AND BUNDLE
↓
EXTRUDE TO ROD
↓
REDUCE TO FINE WIRE

2